# EUROPEAN PATENT APPLICATION

(11) **EP 4 447 095 A2**
(43) Date of publication of application: **16.10.2024**
(21) Application number: 24159936.4
(22) Date of filing: 27.02.2024
(51) Int. Cl.: H01L 21/67, H01L 21/673

(54) **METHOD OF COOLING SUBSTRATE, METHOD OF MANUFACTURING SEMICONDUCTOR DEVICE, SUBSTRATE COOLING SYSTEM, SUBSTRATE PROCESSING APPARATUS, AND PROGRAM**

(30) Priority: 17.03.2023 JP 2023042716
(71) Applicant: Kokusai Electric Corp., Tokyo 1010045 (JP)
(72) Inventor: YAMAGUCHI, Hideto, Toyama-shi, Toyama, 939-2393 (JP); SUGISHITA, Masashi, Toyama-shi, Toyama, 9392393 (JP)
(74) Representative: Bardehle Pagenberg Partnerschaft mbB Patentanwälte Rechtsanwälte

(57) **Abstract**

There is provided a technique that includes: transferring a substrate (1) from a process chamber (14) to a transfer chamber (3), after processing the substrate (1) disposed at the process chamber (14) while detecting a temperature by a temperature sensor (211) installed at a substrate support (31) configured to support the substrate (1); and cooling the substrate (1) so that the temperature detected by the temperature sensor (211) becomes equal to or lower than a set temperature while the substrate support (31) is located at a predetermined position.

## Description

### CROSS-REFERENCE TO RELATED APPLICATION

This application is based upon and claims the benefit of priority from Japanese Patent Application No. 2023-042716, filed on March 17, 2023, the entire contents of which are incorporated herein by reference.

### TECHNICAL FIELD

The present disclosure relates to a method of cooling a substrate, a method of manufacturing a semiconductor device, a substrate cooling system, a substrate processing apparatus, and a program.

### BACKGROUND

In a related art, there are cases in which a predetermined processing is performed on a wafer (hereinafter also referred to as a substrate) as a process of manufacturing a semiconductor device. In a related art, a temperature of a process chamber is controlled by using a temperature detected by a temperature sensor attached to a boat (hereinafter also referred to as a holder). However, it may be challenging to properly control the cooling of the substrate after substrate processing.

### SUMMARY

Some embodiments of the present disclosure provide a technique capable of properly controlling cooling of a substrate.

According to embodiments of the present disclosure, there is provided a technique that includes: transferring a substrate from a process chamber to a transfer chamber, after processing the substrate disposed at the process chamber while detecting a temperature by a temperature sensor installed at a substrate support configured to support the substrate; and cooling the substrate so that the temperature detected by the temperature sensor becomes equal to or lower than a set temperature while the substrate support is located at a position.

### BRIEF DESCRIPTION OF DRAWINGS

The accompanying drawings, which are incorporated in and constitute a part of the specification, illustrate embodiments of the present disclosure.
FIG. 1 is a front cross-sectional view of a substrate processing apparatus according to embodiments of the present disclosure.
FIG. 2 is a schematic diagram illustrating a state of the substrate processing apparatus during boat loading according to embodiments of the present disclosure.
FIG. 3 is a longitudinal cross-sectional view illustrating a configuration of a transfer chamber according to embodiments of the present disclosure.
FIG. 4 is a transverse cross-sectional view illustrating the configuration of the transfer chamber according to embodiments of the present disclosure.
FIG. 5 is a diagram illustrating a hardware configuration of a controller in the substrate processing apparatus according to embodiments of the present disclosure.
FIG. 6 is a diagram illustrating a hardware configuration of a temperature controller in the substrate processing apparatus according to embodiments of the present disclosure.
FIG. 7 is a control block diagram of the temperature controller in the substrate processing apparatus according to embodiments of the present disclosure.
FIG. 8A is a diagram illustrating a substrate processing sequence performed in the substrate processing apparatus according to embodiments of the present disclosure and is a flowchart of the substrate processing sequence. FIG. 8B is a diagram illustrating the substrate processing sequence performed in the substrate processing apparatus according to embodiments of the present disclosure and is a graph illustrating a temperature in each step of the substrate processing sequence.
FIG. 9A is a control block diagram illustrating a method of controlling temperature decrease when a boat and a substrate are located in a process chamber. FIG. 9B is a control block diagram illustrating a method of controlling temperature decrease when the boat and the substrate are located in a transfer chamber.
FIG. 10 is a diagram illustrating control details of the temperature controller, a gas flow rate controller, and a drive controller in each step of the substrate processing sequence.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described above in detail so as not to obscure aspects of the various embodiments.

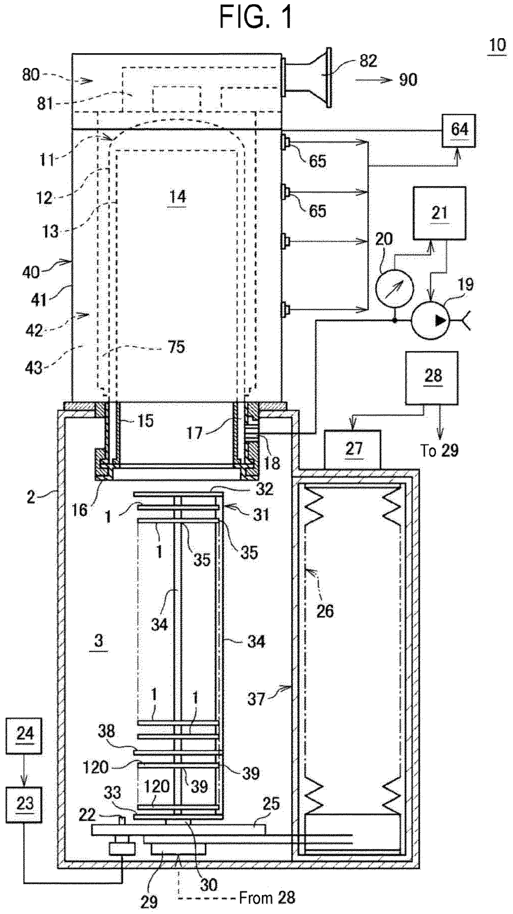

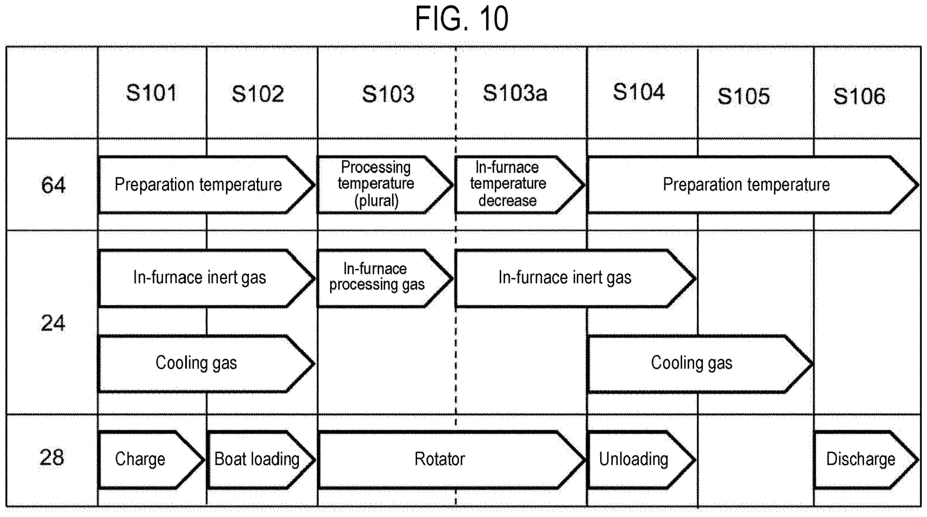

Hereinafter, embodiments of the present disclosure will be described mainly with reference to FIGS. 1 to 10. In addition, the drawings used in the following description are schematic, and the dimensional relationship of each element, the ratio of each element, etc. illustrated in the drawings may not correspond to the reality. Further, the dimensional relationship of each element, the ratio of each element, etc. may not match among a plurality of drawings. Furthermore, the same reference numerals are given to substantially the same elements among the plurality of drawings, and a description of each element is given in the drawing in which that element first appears, and in subsequent drawings, the description is omitted unless particularly demanded. Unless otherwise mentioned in the disclosure, each element is not limited to one and may be present in plurality.

As illustrated in FIG. 1, a substrate processing apparatus 10 includes a vertically supported reaction tube (process tube) 11. The reaction tube 11 includes an outer tube 12 and an inner tube 13, which are arranged concentrically with each other. The outer tube 12 is made of quartz (SiO₂) and is integrally molded into a shape of a cylinder with a closed upper end and an open lower end. The inner tube 13 is formed in a shape of a cylinder with open upper and lower ends. A cylindrical hollow space in the inner tube 13 forms a process chamber 14 into which a boat 31, serving as a substrate support (substrate holder or retainer), is loaded. The lower end (opening) of the inner tube 13 constitutes a furnace opening 15 for an entrance/exit of the boat 31.

A gap between the lower ends of the outer tube 12 and the inner tube 13 is hermetically sealed by a manifold 16 serving as a furnace opening flange constructed in a substantially cylindrical shape. The manifold 16 is detachably attached to each of the outer tube 12 and the inner tube 13, for replacement of the outer tube 12 and the inner tube 13, etc. The manifold 16 is supported by a housing 2 of the substrate processing apparatus 10, so that the reaction tube 11 is in a vertically mounted state.

An exhaust path 17 is constructed by the gap between the outer tube 12 and the inner tube 13 to take a transverse cross-sectional shape in the form of a circular ring with a constant width. As illustrated in FIG. 1, one end of an exhaust pipe 18 is connected to a sidewall upper portion of the manifold 16, and the exhaust pipe 18 is in fluid communication with a lowest end portion of the exhaust path 17. An exhaust device 19, which is controlled by a pressure controller 21, is connected to the other end of the exhaust pipe 18, and a pressure sensor 20 is connected to middle of the exhaust pipe 18. The pressure controller 21 is configured to feedback-control the exhaust device 19 based on measurement results obtained from the pressure sensor 20.

A lid (seal cap) 25 is brought into contact with the manifold 16 from below at a vertical direction to close a lower end opening of the manifold 16. The lid 25 is constructed in a shape of a disk with an outer diameter approximately equal to that of the manifold 16, and is configured to be vertically raised and lowered by a lifter (boat elevator) 26, which is protected by a boat cover 37 provided at a transfer chamber (hereinafter also referred to as a transport chamber) 3 of the housing 2. This allows the boat 31 to move between the process chamber 14 and the transfer chamber 3, which is provided adjacent to and below the process chamber 14. The lifter 26 is composed of a motor-driven feed screw shaft apparatus, a bellows, etc., and a motor 27 of the lifter 26 is configured to be controlled by a drive controller 28. A rotation shaft 30 is positioned on a center axis of the lid 25 and is rotatably supported. The rotation shaft 30 is configured to be rotationally driven by a motor 29 controlled by the drive controller 28. The boat 31 is vertically supported on an upper end of the rotation shaft 30. In this embodiment, the rotation shaft 30 and the motor 29 constitute a rotator.

A gas introduction pipe 22 is disposed at the lid 25 located below the manifold 16, to be in fluid communication with the furnace opening 15 of the inner tube 13. The gas introduction pipe 22 is connected to a precursor gas supplier, a reaction gas supplier, and an inert gas supplier (hereinafter collectively referred to as a gas supplier 23). The gas supplier 23 is configured to be controlled by a gas flow rate controller 24. A gas introduced into the furnace opening 15 from the gas introduction pipe 22 circulates inside the process chamber 14 of the inner pipe 13, then passes through the exhaust path 17, and is exhausted through the exhaust pipe 18.

The boat 31 includes a pair of top and bottom end plates 32 and 33 and three support members in a form of pillars (columns) 34 vertically mounted between them, and multiple holding grooves 35 are carved on the three pillars 34 at equal intervals in a longitudinal direction. The holding grooves 35 carved at a same level on the three pillars 34 are open, facing each other. Each substrate 1 is inserted between the holding grooves 35 at the same level on the three pillars 34, such that the boat 31 aligns and holds a plurality of substrates 1 horizontally and concentrically to each other. Further, each heat-insulation plate 120 is inserted between holding grooves 39 at a same level on the three pillars 34, such that the boat 31 aligns and holds a plurality of heat-insulation plates 120 horizontally and concentrically to each other.

In other words, the boat 31 is configured to distinguish between a substrate processing region between the end plate 32 and an end plate 38 where the plurality of substrates 1 are held and a heat-insulation plate region between the end plate 38 and the end plate 33 where the plurality of heat-insulation plates 120 are held, while the heat-insulation plate region is located below the substrate processing region. The heat-insulation plates 120 held between the end plates 38 and 33 constitute a heat insulator 36.

The rotation shaft 30 is configured to support the boat 31 in a raised state from an upper surface of the lid 25. The heat insulator 36 is provided at the furnace opening 15 and is configured to thermally insulate the furnace opening 15. Further, the boat 31 is rotated by the motor 29 below the lid 25. The motor 29 is in a hollow motor structure, with the rotation shaft 30 passing through the motor 29.

A heater unit 40, serving as a heating apparatus, is arranged concentrically outside the reaction tube 11 and is installed in a supported state by the housing 2. A heater thermocouple 65, serving as a temperature sensor, is installed in a vicinity of the heater unit 40, and a temperature controller 64 is configured to feedback-control the heater unit 40 based on measurement results obtained from the heater thermocouple 65. This allows the heater unit 40 to heat the substrate 1 held by the boat 31 within the substrate processing region. In addition, details regarding the heater thermocouple 65 will be described later. Further, the heater unit 40 includes a case 41. The case 41 is made of stainless steel (SUS) and is formed in a shape of a cylinder, particularly, a circular cylinder, with a closed upper end and an open lower end. An inner diameter and an overall length of the case 41 are set larger than an outer diameter and an overall length of the outer tube 12.

A heat-insulation structure 42 is installed inside the case 41. The heat-insulation structure 42 includes an outer layer arranged at an exterior and an inner layer arranged at an interior, and is formed in a shape of a cylinder, with a sidewall 43 of the cylinder formed into a multi-layered structure.

Then, cooling air 90 is guided to flow through a gas supply flow path provided within the inner layer and to be supplied to a space 75 through the gas supply flow path.

As illustrated in FIG. 1, the sidewall 43 of the heat-insulation structure 42 is covered at an upper end with a ceiling wall 80 serving as a ceiling, to close the space 75. The ceiling wall 80 includes an exhaust hole 81 formed in an annular shape as a part of an exhaust path for exhausting atmosphere of the space 75, and a lower end, which is an upstream end, of the exhaust hole 81 is in fluid communication with the inner space 75. A downstream end of the exhaust hole 81 is connected to an exhaust duct 82. Then, the cooling air 90 ejected into the space 75 is exhausted through the exhaust hole 81 and the exhaust duct 82.

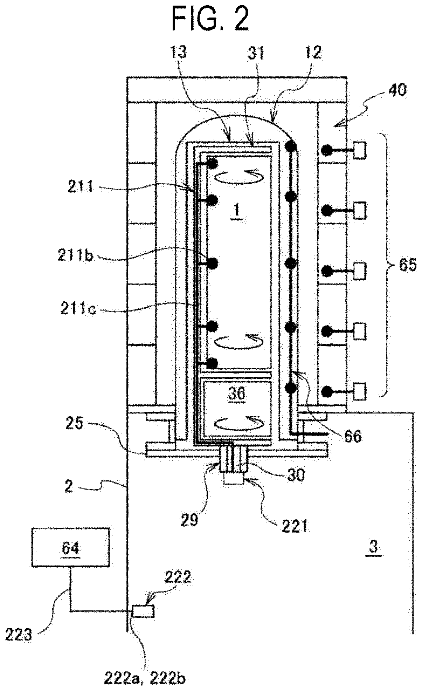

As illustrated in FIG. 2, the heater unit 40 is divided into a plurality of independently controllable zones in a vertical direction, with a heater provided for each zone, so that a plurality of heaters are stacked. In FIG. 2, the heater unit 40 is divided into 5 zones. Then, the heater thermocouple 65 is allotted for each zone to measure a temperature of each heater. In FIG. 2, the processing substrate is denoted as "1," and the illustration thereof is omitted.

An in-furnace thermocouple 66, serving as a temperature sensor, is attached inside the outer tube 12 to measure the temperature inside the tube. The in-furnace thermocouple 66 is in a structure in which a number of thermocouples corresponding to the number of zones are accommodated within one quartz tube. Then, temperature measurement points are provided at positions opposite the respective zones.

A substrate thermocouple 211, serving as a temperature sensor, is provided at the boat 31 to measure a temperature of the substrate 1, and is configured to rotate together with the substrate 1 when the boat 31 rotates to rotate the substrate 1. The substrate thermocouple 211 is configured to include a temperature detector (a temperature-measuring part) 211b that measures the temperature of the substrate 1 and a cable 211c including a wire constituting the temperature detector.

The heater thermocouple 65, the substrate thermocouple 211, and the in-furnace thermocouple 66 are examples of temperature sensors. In addition, the temperature sensors are not limited to these thermocouples as long as they may measure temperatures as electric signals and may also be other sensors such as temperature sensitive resistors.

The rotation shaft 30 includes a bore through which the cable 211c passes and is structured to allow the cable 211c to be pulled out to a transmitter 221 outside the process chamber 14 (e.g., below the rotation shaft 30) while being vacuum-sealed using a hermetic seal, etc. The cable 211c is connected to the transmitter 221 below the lid 25.

The transmitter 221 is fixed to the rotation shaft 30 and is configured to move together with the rotation shaft 30. The transmitter 221 digitally converts electric signals (voltage) input through the cable 211c from the substrate thermocouple 211 to transmit the signals converted wirelessly by radio waves.

A receiver 222 is fixed to the housing 2 of the transfer chamber 3 below the lid 25. The receiver 222 receives the signals emitted from the transmitter 221, and includes a terminal (output terminal) 222a for serial communication output of the digital signals received, or a terminal (output terminal) 222b that converts the digital signals received into analog signals such as 4 mA to 20 mA to output them. A cable 223 connects an output signal terminal of these digital signals or analog signals to a temperature indicator (not illustrated) or the temperature controller 64, enabling the input of temperature data to the temperature controller 64. In addition, the receiver 222 is installed at the transfer chamber 3, but is not limited thereto. It may be located outside the transfer chamber 3, or may be located at a position away from the substrate processing apparatus 10.

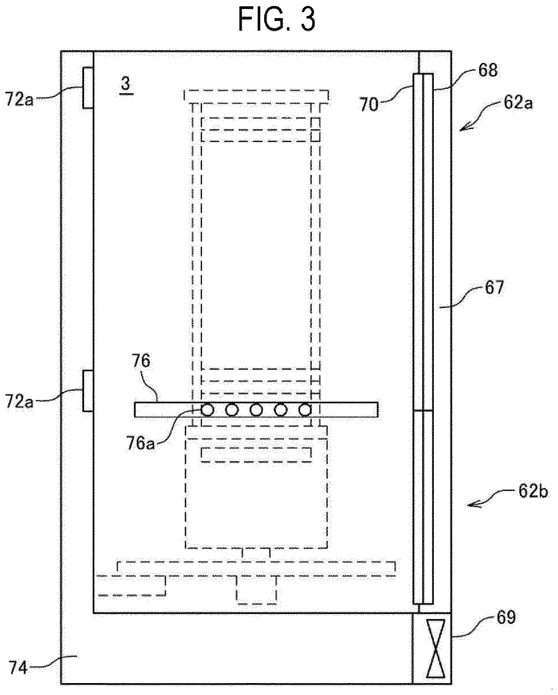

Next, a configuration of the transfer chamber 3 in the embodiments of the present disclosure will be described with reference to FIGS. 3, 4, 9A and 9B.

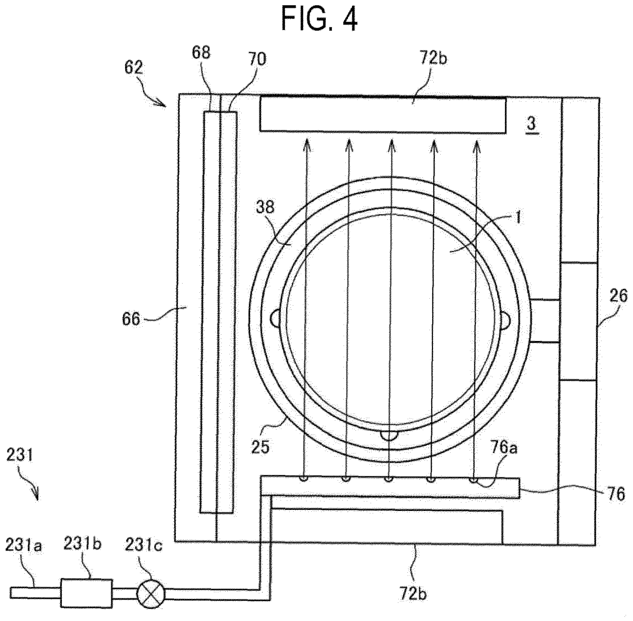

As illustrated in FIGS. 3 and 4, the transfer chamber 3 is configured in a multi-sided polygonal shape, for example, in a planar square shape, with a ceiling, a bottom, and surrounding side walls. A clean unit 62 as cleaning parts is installed at one side of the transfer chamber 3. The clean unit 62 supplies a gas as clean air to the transfer chamber 3. Further, a circulation path 74 is formed in a space surrounding the transfer chamber 3 to circulate the gas. The gas supplied to the transfer chamber 3 is exhausted from an exhauster 72 and is supplied again to the transfer chamber 3 from the clean unit 62 by way of the circulation path 74. A radiator (not illustrated) is provided at middle of the circulation path 74, so that the gas is cooled by passing through the radiator.

The clean unit 62 is arranged such that an upper clean unit 62a and a lower clean unit 62b are vertically adjacent to each other. The upper clean unit 62a is configured to supply a gas mainly toward the substrate processing region of the boat 31 when the boat 31 is in the transfer chamber 3. The lower clean unit 62b is configured to supply a gas mainly toward the heat insulator 36 in the heat-insulation plate region of the boat 31 when the boat 31 is in the transfer chamber 3. Hereinafter, when referred to as the clean unit 62, it may indicate the upper clean unit 62a, the lower clean unit 62b, or both.

The clean unit 62 includes a fan 69, a buffer area 67, a filter 68, and a gas supply port 70, arranged in order from an upstream. The buffer area 67 is a diffusion space for evenly ejecting the gas from an entire surface of the gas supply port 70. The filter 68 is configured to remove particles contained in the gas.

A side exhauster 72a and the lifter 26 are attached to one side at a side opposite to the clean unit 62. The gas supplied from the upper clean unit 62a to the transfer chamber 3 is mainly exhausted by the side exhauster 72a and is supplied again to the transfer chamber 3 from the clean unit 62 by way of the circulation path 74. This creates a substantially horizontal gas flow parallel to the substrate 1 in an upper region (region where the substrate 1 is located) of the transfer chamber 3.

As illustrated in FIG. 4, a pair of bottom exhausters 72b are installed at a bottom of the transfer chamber 3 with the boat 31 sandwiched therebetween. Each of the bottom exhausters 72b is formed in a rectangular shape along one side of the transfer chamber 3. The gas supplied from the lower clean unit 62b to the transfer chamber 3 is mainly exhausted from the bottom exhausters 72b and is supplied again to the transfer chamber 3 from the clean unit 62 by way of the circulation path 74. This creates a substantially vertical downward gas flow in a lower region of the transfer chamber 3 (region where the heat insulator 36 is located).

As illustrated in FIGS. 3 and 4, a nozzle 76, serving as cooling parts, is installed above the bottom exhausters 72b and in the vicinity of a boundary between the upper clean unit 62a and the lower clean unit 62b. The nozzle 76 extends horizontally and includes a plurality of supply holes 76a to supply a cooling gas as a coolant to the vicinity of the boundary between the substrate processing region and the heat-insulation plate region of the boat 31.

The nozzle 76 is connected to a cooling gas supplier 231 for supplying the cooling gas to the transfer chamber 3. The cooling gas supplier 231 is provided with a supply pipe 231a connected to the nozzle 76, a mass flow controller (MFC) 231b, and a valve 231c. Further, the nozzle 76 and the cooling gas supplier 231 constitute a cooler.

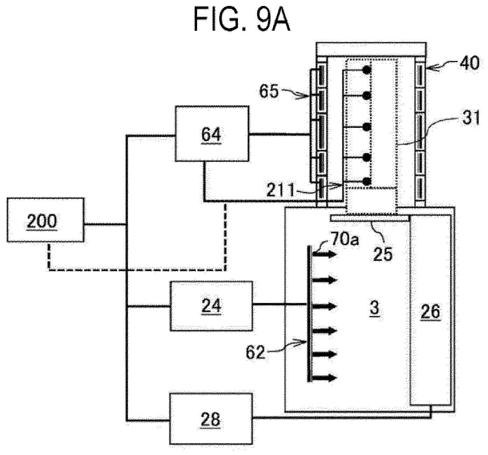

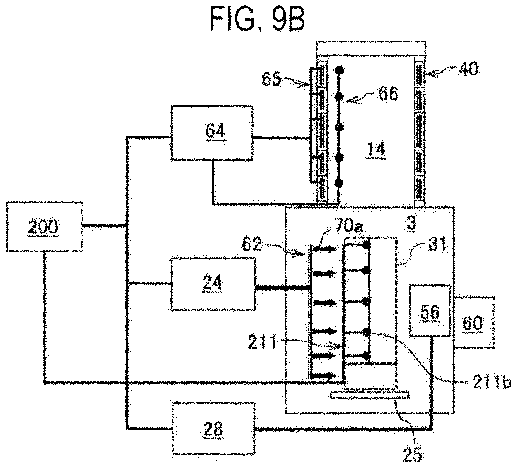

As illustrated in FIGS. 9A and 9B, the clean unit 62 is vertically divided and is configured to eject the gas from a plurality of supply holes 70a provided at the gas supply port 70. The clean unit 62 is configured such that the plurality of supply holes 70a may independently turn gas ejection on or off and regulate a gas flow rate, respectively, in response to a plurality of instructions output from the gas flow rate controller 24. As illustrated in FIG. 9B, the clean unit 62 includes each of the supply holes 70a at each position opposite to the temperature detector 211b of the substrate thermocouple 211 provided at the boat 31 and at a position of the heat insulator 36, and supplies the cooling gas as a coolant. The clean unit 62 is also referred to as cooling parts and constitutes a cooler.

As illustrated in FIG. 9B, a substrate transfer machine 56 is arranged in the transfer chamber 3. The substrate transfer machine 56 includes an arm (tweezer) capable of taking out, for example, five substrates 1. The substrate transfer machine 56 is configured to be able to transfer the substrate 1 between a pod 60 and the boat 31 by rotating the tweezer up and down using a driver (not illustrated).

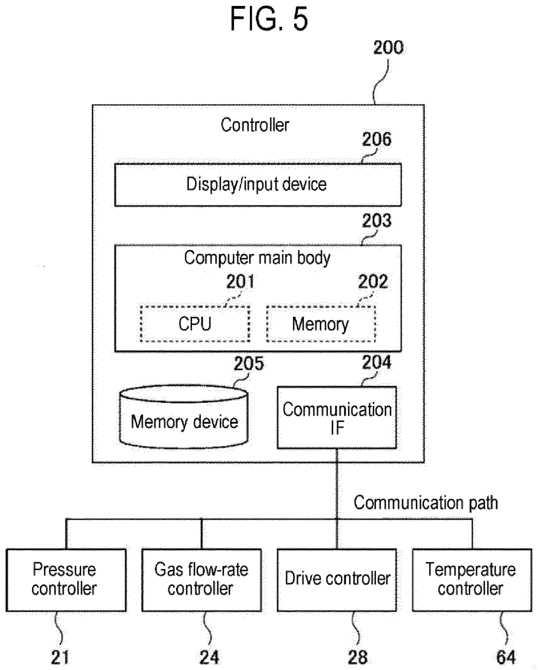

As illustrated in FIG. 5, a controller 200, which is a control computer as a control part, includes a computer main body 203 including a central processing unit (CPU) 201, a memory 202, etc., a communication interface (IF) 204 as a communicator, a memory device 205 as a memory part, and a display/input device 206 as an operator. In other words, the controller 200 includes components as a general computer.

The CPU 201 constitutes a core of the operator, and executes a control program stored in the memory device 205, thus executing recipes (e.g., process recipes) recorded in the memory device 205 in response to instructions from the display/input device 206. Further, the memory 202, serving as a temporary memory, functions as a work area for the CPU 201.

Further, a way for supplying programs to the computer is not limited to supplying the programs via the memory device 205. For example, a communication facility such as the Internet or dedicated lines may be used to supply the programs without going through the memory device 205. In addition, the memory 202 and the memory device 205 are configured as computer-readable recording media. Hereinafter, these are collectively referred to as recording media. In addition, when the term "recording media" is used in the present disclosure, it may refer to the memory 202, the memory device 205, or both.

The communication IF 204 is electrically connected to the pressure controller 21, the gas flow rate controller 24, the drive controller 28, and the temperature controller 64 (sometimes collectively referred to as sub-controllers) via a communication path. The controller 200 may exchange data, regarding the operation of each component, with the sub-controllers through the communication IF 204.

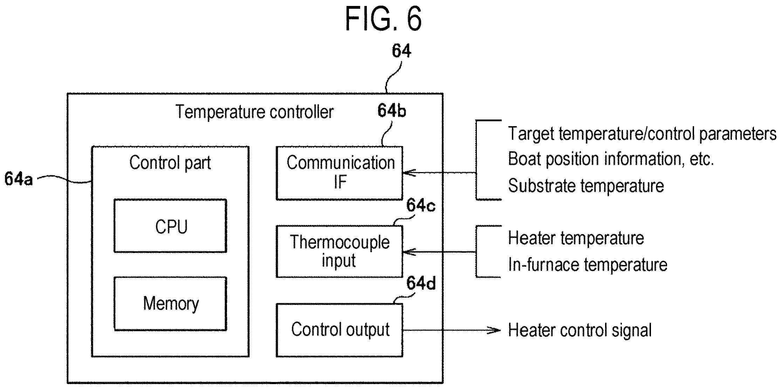

As illustrated in FIG. 6, the temperature controller 64 includes a control part 64a, a communication IF 64b, a thermocouple input 64c, and a control output 64d.

The control part 64a includes a hardware configuration as a general computer including a CPU, memory, etc. By executing a control program, the control part 64a executes control calculations according to a temperature control algorithm to be described later by using information acquired by the communication IF 64b and the thermocouple input 64c, thus outputting calculation results to the control output 64d.

The communication IF 64b includes a wired IF for connection to an upper-level controller such as the controller 200 and a wireless IF such as the receiver 222 for connection to the transmitter 221 fixed to the boat 31.

The communication IF 64b receives information such as a target temperature and control parameters from the controller 200, or transmits control calculation results and temperature information. Further, the communication IF 64b receives boat position information from the drive controller 28 of the lifter 26. Further, the communication IF 64b receives a temperature from of the substrate thermocouple 211 through the transmitter 221 and the receiver 222.

The thermocouple input 64c inputs electric signals corresponding to temperatures from the heater thermocouple 65 and the in-furnace thermocouple 66, converts these electric signals into digital signals, and outputs them to the control part 64a.

The control output 64d outputs a heater control signal for performing temperature control of the heater unit 40 based on the calculation results received from the control part 64a.

In the following description, a temperature detected by the heater thermocouple 65 is referred to as a heater temperature, and temperature control using the heater thermocouple 65 is referred to as heater temperature control. Further, a temperature detected by the substrate thermocouple 211 is referred to as a substrate temperature, and temperature control using the substrate thermocouple 211 is referred to as substrate temperature control. Further, a temperature detected by the in-furnace thermocouple 66 is referred to as an in-furnace temperature, and temperature control using the in-furnace thermocouple 66 is referred to as in-furnace temperature control.

In addition, the controller 200 may obtain a measured temperature as information from the substrate thermocouple 211 through the temperature controller 64, or directly from the substrate thermocouple 211. The controller 200 then may use the measured temperature as input information for situation display, error processing, and recipe operation management in the controller 200.

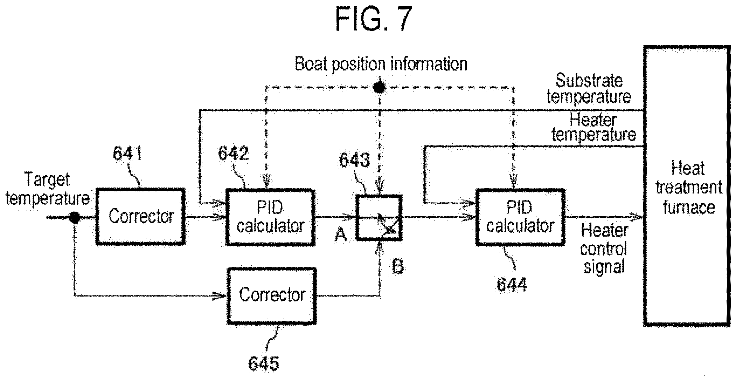

Next, an example of a control block of the temperature controller 64 in the embodiments of the present disclosure will be described with reference to FIG. 7.

The control block includes a mode with a corrector 641, a PID calculator 642, a switcher 643, and a PID calculator 644 connected in sequence, and a mode with a corrector 645, the switcher 643, and the PID calculator 644 connected in sequence. The boat position information is input to the PID calculator 642, the PID calculator 644, and the switcher 643. In addition, a control target is a heat treatment furnace, and the heat treatment furnace is composed of the reaction tube 11 and the heater unit 40, and includes the heater thermocouple 65 and the substrate thermocouple 211.

The temperature controller 64 selects an input terminal of the switcher 643 according to the boat position information.

When the boat 31 is located at a closed position (inside the process chamber 14), the temperature controller 64 selects an input terminal "A" of the switcher 643 to perform PID control using the substrate temperature and the heater temperature as control target quantities.

The control with the input terminal "A" of the switcher 643 is an example of a second control mode in the technique of the present disclosure. The second control mode is a control mode that uses at least the substrate thermocouple 211 for control, among the heater thermocouple 65 and the substrate thermocouple 211.

When the boat 31 is located at a position (for example, inside the transfer chamber 3) other than the closed position, the temperature controller 64 selects an input terminal "B" of the switcher 643 to perform PID control using the heater temperature as a control target quantity.

The control with the input terminal "B" of the switcher 643 is an example of a first control mode in the technique of the present disclosure. The first control mode is a control mode that uses the heater thermocouple 65 for control, among the heater thermocouple 65 and the substrate thermocouple 211.

The correctors 641 and 645 correct the target temperature according to the differences between the target temperature, the heater temperature, the substrate temperature, etc. when controlling an interior of the process chamber 14 to an equivalent temperature.

This switching of the switcher 643 causes a jump in an output of the switcher 643 to generate discontinuous values. As such, the boat position information is also input to the PID calculators 642 and 644 to ensure smooth control before and after the switching by so-called bumpless processing, integral stop processing, etc.

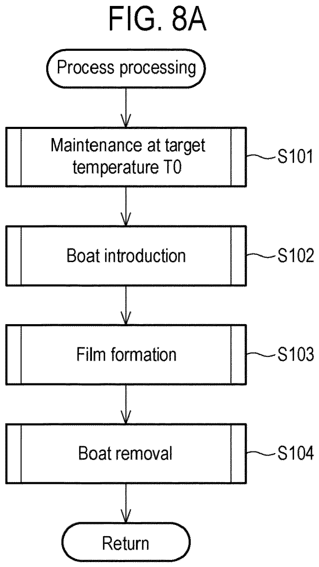

Next, an example of a substrate processing sequence performed in the substrate processing apparatus 10 will be described with reference to FIGS. 8A, 8B, 9A, 9B and 10.

### (Standby Step (Transfer Step): Step S101)

The standby step is a processing of stabilizing an internal temperature of the process chamber 14 (also referred to as in-furnace) to a target temperature T0, which is a standby temperature (preparation temperature). The substrate 1 is not yet introduced into the process chamber 14. In other words, the boat 31 is in the state as illustrated in FIG. 9B, and the lower end opening of the process chamber 14 (manifold 16 illustrated in FIG. 1) is closed by a shutter (not illustrated).

To set the process chamber 14 to the preparation temperature, the temperature controller 64 inputs a detected temperature from the in-furnace thermocouple 66 or a detected temperature from the heater thermocouple 65 to control the heater unit 40.

The gas flow rate controller 24 supplies an inert gas into the process chamber 14 by a gas supplier and a nozzle (none of which are illustrated). Concurrently, the gas flow rate controller 24 supplies a cooling gas to the transfer chamber 3 from the supply holes 76a through the nozzle 76 by the cooling gas supplier 231, and also supplies a cooling gas to the transfer chamber 3 from each of the supply holes 70a by the clean unit 62.

The drive controller 28 transfers (charges) the substrate 1 from the pod 60 to the boat 31 by the substrate transfer machine 56. Step S101 is also referred to as a transfer step.

### (Loading Step: Step S102)

The loading step is a processing of introducing the substrate 1, held in the boat 31, into the process chamber 14 (boat loading). The lower end opening of the process chamber 14 is opened, and the drive controller 28 raises the boat 31 by the lifter 26 to load it into the process chamber 14. Once the loading of the boat 31 is completed, the lower end opening of the process chamber 14 is closed by the lid 25, and the boat 31 is disposed at a predetermined position inside the process chamber 14, as illustrated in FIG. 9A.

In the loading step, following the transfer step, the gas flow rate controller 24 continues to supply the inert gas into the process chamber 14 and the cooling gas to the transfer chamber 3.

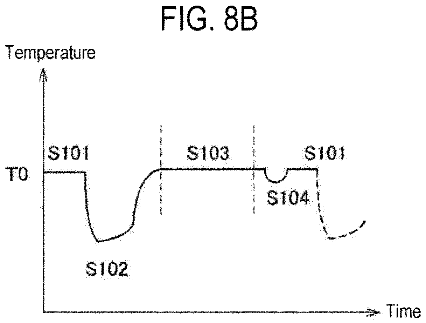

The boat 31 and the substrate 1 have a temperature lower than the internal temperature (i.e., T0) of the process chamber 14, before being loaded into the process chamber 14. Further, the introduction of the substrate 1 into the process chamber 14 results in introduction of outside atmosphere (room temperature) of the process chamber 14 into the process chamber 14. Therefore, as illustrated in FIG. 8B, the internal temperature of the process chamber 14 temporarily drops below T0. Thereafter, the internal temperature of the process chamber 14 is again stabilized to T0 after a brief period under control by the temperature controller 64. In FIG. 8B, a target temperature in the next step S103 and after the introduction of the processing substrate into the process chamber 14 is illustrated as being the same as in step S101, but the target temperature after the introduction may vary depending on a demanded condition (processing temperature) of step S103.

### (Processing Step: Step S103)

The processing step is a processing of maintaining and stabilizing the internal temperature of the process chamber 14 at the target temperature T0 of a processing temperature, in order to perform a predetermined processing (e.g., film formation) on the substrate 1. The temperature controller 64 controls the heater unit 40 so that the measured temperature from the substrate thermocouple 211 approaches the target temperature T0. The processing temperature in the present disclosure refers to the temperature of the substrate 1 or the internal temperature of the process chamber 14.

The gas flow rate controller 24 supplies a precursor gas, a reaction gas, or an inert gas (these are collectively referred to as a processing gas) into the process chamber 14 through the gas introduction pipe 22 by the gas supplier 23. The drive controller 28 rotates the boat 31 by the rotator. When multiple types of processing gases are supplied, multiple processing temperatures are set corresponding to the processing gases supplied.

In addition, the processing step involves, after completion of the predetermined processing on the substrate 1, a processing of decreasing the internal temperature of the process chamber 14 (in-furnace temperature decrease) until it reaches a predetermined temperature. This processing is a sub-step of step S103 and is referred to as a temperature decrease step (step S103a). After that, transition to an unloading step (step S104) is made.

Further, when the detected temperature from the in-furnace thermocouple 66 or the detected temperature from the heater thermocouple 65 is used as a monitoring temperature for controlling a temperature decrease time, a deviation from the temperature of the substrate 1 is larger compared to using the detected temperature from the substrate thermocouple 211, which may either waste a long time with respect to the temperature decrease time or cause damage to the transfer chamber 3 due to heat.

In the embodiments of the present disclosure, since the substrate thermocouple 211 may accurately measure the temperature of the substrate 1, the temperature decrease time may be optimally controlled by continuing the temperature decrease step until this temperature drops to the predetermined temperature while monitoring this temperature, and then starting the unloading step after temperature decrease. This makes it possible to control the temperature decrease time to be the shortest and without damaging the surroundings, even if the temperature of the substrate 1 varies. Here, the predetermined temperature is a temperature at which the boat 31 may be unloaded and is less than or equal to a heat-resistant temperature of the transfer chamber 3.

More specifically, the temperature controller 64 inputs the detected temperature from the substrate thermocouple 211 to perform feedback-control. The gas flow rate controller 24 supplies an inert gas into the process chamber 14, as in the standby step. The drive controller 28 rotates the boat 31 and the substrate thermocouple 211 by the rotation shaft 30.

On the other hand, the controller 200 similarly inputs and monitors the detected temperature from the substrate thermocouple 211. Then, the controller 200 continues the temperature decrease step until the timing when the entire detected temperatures drop to or below the predetermined temperature. In other words, a determiner of the controller 200 determines completion of substrate temperature decrease and transition to the next step (unloading step). The determiner may determine that the substrate temperature drop is completed when the detected temperature remains at or below the predetermined temperature for a predetermined time.

Since the determination may be made by comparing the temperature detected by the substrate thermocouple 211, which is closer to the substrate 1 than the in-furnace thermocouple 66, with the predetermined temperature (set temperature), it is possible to properly manage a timing of the unloading step.

### (Unloading Step: Step S104)

The unloading step is a processing of removing the substrate 1 processed from the interior of the process chamber 14 together with the boat 31 and the substrate thermocouple 211 (boat unloading). The drive controller 28 lowers the boat 31 and the substrate thermocouple 211 by the lifter 26 to unload (transfer) them to the transfer chamber 3. As the boat 31 is lowered, the lower end opening of the process chamber 14 is opened. After that, the boat 31 is disposed at a preset position as illustrated in FIG. 9B. Further, the lower end opening of the process chamber 14 is closed.

In the unloading step, following the temperature drop step, the gas flow rate controller 24 continues to supply the inert gas into the process chamber 14. Concurrently, the gas flow rate controller 24 supplies the cooling gas into the transfer chamber 3, as in the standby step.

To set the process chamber 14 to the preparation temperature, the temperature controller 64 inputs, instead of the detected temperature from the substrate thermocouple 211, the detected temperature from the in-furnace thermocouple 66 or the detected temperature from the heater thermocouple 65 to control the heater unit 40. In the subsequent cooling step and transfer step to be described later, the temperature controller 64 sets the process chamber 14 to the preparation temperature based on the detected temperature from the in-furnace thermocouple 66 or the detected temperature from the heater thermocouple 65.

After the unloading step, while the boat 31 is disposed at the preset position inside the transfer chamber 3 as illustrated in FIG. 9B, a cooling step of decreasing (cooling) the temperature of the substrate 1 (step S105) is executed, and thereafter, a transfer step (step S106) is executed.

### (Cooling Step: Step S105)

In the cooling step, following the unloading step, the gas flow rate controller 24 continues to supply the cooling gas to the transfer chamber 3, thus decreasing (cooling) the temperature of the substrate in the transfer chamber 3 until the detected temperature from the substrate thermocouple 211 reaches a predetermined temperature.

Setting a temperature decrease time to a fixed time may waste a long time with respect to the temperature decrease time when the temperature of the substrate 1 varies. Alternatively, the next transfer step may be started before the temperature of the substrate 1 drops to the predetermined temperature resulting in damage to the substrate transfer machine 56 or the pod 60 due to heat.

In the embodiments of the present disclosure, since the substrate thermocouple 211 accurately measures the temperature of the substrate 1 in the transfer chamber 3 as well, the temperature decrease time may be optimally controlled by continuing the cooling step until this temperature decreases to the predetermined temperature (to or below a set temperature) while monitoring this temperature, and then starting the transfer step after the temperature decrease. Therefore, it is possible to control the temperature drop time to be the shortest and without damaging the surroundings, even if the temperature of the substrate 1 varies. Herein, the predetermined temperature is a temperature at which the substrate 1 may be transferred and is less than or equal to a heat-resistant temperature of the pod 60 or the substrate transfer machine 56 that transfers the substrate 1 between the boat 31 and the pod 60.

Further, in the embodiments of the present disclosure, the substrate thermocouple 211, which is used when controlling the heater unit 40 to process the substrate disposed at the process chamber 14 in the processing step, is also used in the cooling step to measure the temperature of the substrate 1 located in the transfer chamber 3. Therefore, there is no need to newly install components to measure the temperature of the substrate 1 in the transfer chamber 3.

More specifically, the temperature controller 64 inputs the detected temperature from the in-furnace thermocouple 66 or the heater thermocouple 65 to perform feedback-control, as in the standby step, the loading step, and the unloading step described above.

On the other hand, the controller 200 instructs the gas flow rate controller 24 to supply the cooling gas from the clean unit 62 to the transfer chamber 3, from the unloading step to the cooling step. The controller 200 is able to regulate the flow rate of the cooling gas from the clean unit 62. Then, the controller 200 inputs the detected temperature from the substrate thermocouple 211 to monitor the detected temperature from the substrate thermocouple 211 in entire zones. Then, the controller 200 continues the cooling step until the timing when the entire detected temperatures drop to or below the predetermined temperature. In other words, the determiner of the controller 200 determines completion of substrate cooling and transition to the next step (transfer step). The determiner may determine that substrate cooling is completed when the detected temperature remains at or below the predetermined temperature for a predetermined time. A control target of the substrate thermocouple 211 is the clean unit 62 as a cooler.

In the cooling step, the controller 200 may control as follows.

The controller 200 instructs the gas flow rate controller 24 to supply the cooling gas to the clean unit 62, from the unloading step to the cooling step. Then, the controller 200 inputs and monitors the detected temperatures from a plurality of temperature detectors 211b of the substrate thermocouple 211 disposed in a vertical direction. Then, the controller 200 continues to supply the cooling gas from a supply hole 70a of the clean unit 62 at a position corresponding to a temperature detector 211b of the substrate thermocouple 211 located in a specific zone until the timing when a detected temperature from the substrate thermocouple 211 drops to or below a predetermined temperature. After that, the controller 200 stops the supply of the cooling gas from the supply hole 70a of the clean unit 62 at the position corresponding to the temperature detector 211b of the substrate thermocouple 211 located in the specific zone. The controller 200 continues the cooling step until the supply of the cooling gas from the entire supply holes 70a of the clean unit 62 is stopped, i.e., until the entire detected temperatures from the temperature detectors 211b of the substrate thermocouple 211 drop to or below the predetermined temperature. In other words, the determiner of the controller 200 determines the completion of substrate cooling and the transitions to the next step (transfer step). The determiner may determine that substrate cooling is completed when the detected temperature remains at or below the predetermined temperature for the predetermined time.

If the specific zone is, for example, a zone where the most heat accumulates, cooling of the specific zone will take longer than cooling of the other zones, so the completion of substrate cooling may be determined when a detected temperature from the substrate thermocouple 211 located in the specific zone is at or below the predetermined temperature.

Further, in the cooling step, the controller 200 and the gas flow rate controller 24 may control as follows.

The gas flow rate controller 24 may obtain, from the controller 200, the detected temperature from the substrate thermocouple 211, and feedback-controls a gas ejection flow rate of a clean unit 62 corresponding to a disposed position of the substrate thermocouple 211 based on a target predetermined cooling temperature obtained similarly from the controller 200.

The controller 200 instructs the gas flow rate controller 24 with a predetermined cooling temperature for the substrate thermocouple 211 corresponding to each supply hole 70a of the clean unit 62, from the unloading step to the cooling step. Concurrently, the controller 200 also outputs the detected temperature from the substrate thermocouple 211 to the gas flow rate controller 24.

The gas flow rate controller 24 inputs and feedback-controls the detected temperatures from the plurality of temperature detectors 211b of the substrate thermocouple 211 disposed in a vertical direction. Then, the gas flow rate controller 24 continues to supply the cooling gas from the supply hole 70a of the clean unit 62 at the position corresponding to the temperature detector 211b of the substrate thermocouple 211 located in the specific zone until the timing when the detected temperature from the substrate thermocouple 211 drops to or below the predetermined temperature. After that, the gas flow rate controller 24 stops the supply of the cooling gas from the supply hole 70a of the clean unit 62 at the position corresponding to the temperature detector 211b of the substrate thermocouple 211 located in the specific zone. The gas flow rate controller 24 continues the cooling step until the entire detected temperatures from the temperature detectors 211b of the substrate thermocouple 211 drop to or below the predetermined temperature. In other words, the gas flow rate controller 24 determines the completion of substrate cooling and the transitions to the next step (transfer step). The gas flow rate controller 24 may determine that substrate cooling is completed when the detected temperature remains at or below the predetermined temperature for the predetermined time.

### (Transfer Step: Step S106)

After step S105, the drive controller 28 transfers the substrate 1 from the boat 31 to the pod 60 by the substrate transfer machine 56 (discharge step).

If there are still unprocessed substrates 1 to be processed, the series of processing from steps S101 to S106 will be repeated. Steps S101 to S106 are performed after obtaining a stable state where the internal temperature of the process chamber 14 is within a predefined small temperature range with respect to the target temperature and remains for a predefined time or longer.

According to the embodiments of the present disclosure, one or a plurality of effects described below are acquired.
(a) Cooling is performed until the temperature detected by the substrate thermocouple 211 provided at the boat 31 reaches a set temperature. This allows the substrate 1 to be cooled simply by monitoring that the temperature drops to or below a predetermined temperature (set temperature) using the substrate thermocouple 211 provided at the boat 31. Further, even if there is a variation in the temperature of the substrate 1 among the substrates 1 supported by the boat 31, the temperature may be detected using the substrate thermocouple 211 provided at the boat 31, so that the substrate 1 may be accurately cooled to or below the predetermined temperature (set temperature).
(b) Cooling is performed until the temperature detected by the temperature detector 211b of each substrate thermocouple 211 provided at the boat 31 reaches the set temperature. This allows the substrate 1 to be cooled simply by monitoring that the temperature drops to or below the predetermined temperature (set temperature) using the substrate thermocouple 211 provided at the boat 31.
(c) Cooling is performed until the temperature detected by the temperature detector 211b of the substrate thermocouple 211 disposed in a specific zone reaches the set temperature. This allows the cooling of the substrate 1 disposed in the boat 31 to be determined to be complete if the temperature detected by the temperature detector 211b of the substrate thermocouple 211 disposed in the specific zone is at the set temperature.
(d) The cooling of the substrate 1 is determined to be complete when the temperature detected by the substrate thermocouple 211 provided at the boat 31 remains at or below a set temperature for a predetermined period. The determination is made by monitoring the variation of the temperature detected by the substrate thermocouple 211 provided at the boat 31, allowing the substrate 1 to be cooled to or below the predetermined temperature (set temperature).
(e) In the cooling step (step S105), a control target of the substrate thermocouple 211 provided at the boat 31 is a cooler that cools the substrate 1. This allows the substrate 1 to be cooled by the driving of the cooler based on the temperature detected by the substrate thermocouple 211 provided at the boat 31.
(f) In each of the cooling step (step S105) and the processing step (step S103), the processing of the substrate 1 or the cooling of the substrate 1 may be controlled based on the temperature detected by the substrate thermocouple 211 provided at the boat 31, which significantly improves temperature controllability, thus enabling highly accurate temperature control. Further, there is no need to newly install components to measure the temperature of the substrate 1 in the transfer chamber 3.
(g) The transfer chamber 3 is provided with the clean unit 62 that supplies a cooling gas. This allows the transfer chamber 3 to be cooled by the clean unit 62, so that the substrate 1 may be cooled within a short time.
(h) The clean unit 62 includes the supply hole 70a that supplies the cooling gas at a position opposite the substrate thermocouple 211. This allows the transfer chamber 3 to be cooled by the clean unit 62, so that the substrate 1 may be cooled within a short time.
(i) The clean unit 62 as a cooler is configured to change a flow rate of a coolant for each supply hole 70a. This allows the transfer chamber 3 to be cooled by the clean unit 62, so that the substrate 1 may be cooled within a short time.
(j) The controller 200 includes the determiner, and the determiner is configured to determine whether the cooling of the substrate 1 is complete, and the transition to the next step (transfer step). This ensures that advancement to the next step (transition to the next step) is made once it is determined that the cooling of the substrate 1 is complete, allowing the sufficient cooling of the substrate 1 and preventing damage to the tweezer of the substrate transfer machine 56 or the pod 60 in the next transfer step.
(k) The determiner determines that the cooling of the substrate 1 is complete if the temperatures detected by the entire temperature detectors 211b of the substrate thermocouple 211 (in each zone) reach the set temperature. This ensures that it is advanced to the next step (transition to the next step) when it is determined that the cooling of the substrate 1 is complete, allowing the sufficient cooling of the substrate 1 and preventing damage to the tweezer of the substrate transfer machine 56 or the pod 60 in the next transfer step.
(l) The determiner determines that the cooling of the substrate 1 is complete if the temperature detected by the temperature detector 211b of the substrate thermocouple 211 arranged in a specific location zone (e.g., where the most heat accumulates) reaches the set temperature. This ensures that it is advanced to the next step (transition to the next step) when it is determined that the cooling of the substrate 1 is complete, allowing the sufficient cooling of the substrate 1 and preventing damage to the tweezer of the substrate transfer machine 56 or the pod 60 in the next transfer step.
(m) The determiner determines that the cooling of the substrate 1 is complete when the temperature detected by the substrate thermocouple 211 remains at or below the set temperature for the predetermined time, This ensures that it is advanced to the next step (transition to the next step) when it is determined that the cooling of the substrate 1 is complete, allowing the sufficient cooling of the substrate 1 and preventing damage to the tweezer of the substrate transfer machine 56 or the pod 60 in the next transfer step.
(n) There is provided a transporter configured to be able to move the boat 31 between the process chamber 14 and the transfer chamber 3. This allows the substrate thermocouple 211 provided at the boat 31 to move together with the boat 31, so that the temperature of the substrate 1 may be detected in both the process chamber 14 and the transfer chamber 3, which significantly improves the temperature controllability, thus enabling highly accurate temperature control.
(o) The transfer chamber 3 is configured to be adjacent to the process chamber 14. For example, the transfer chamber 3 is configured to be located below the process chamber 14. Thus, the substrate thermocouple 211 is provided at the boat 31 to move together with the boat 31, so that the temperature of the substrate 1 may be detected in both the process chamber 14 and the transfer chamber 3, which significantly improves the temperature controllability, thus enabling highly accurate temperature control.

The above is a specific description of the embodiments of the present disclosure. However, the present disclosure is not limited to the above-described embodiments, and may be changed in various ways without departing from the gist thereof.

Although one zone is described in the above embodiment, there may be a plurality of zones in reality, and movement average parameters may also be set for each zone. Further, the movement average parameters may also be set accordingly for each temperature (or temperature range).

The substrate processing apparatus may be applied to an apparatus that processes a glass substrate such as an LCD apparatus, in addition to a semiconductor manufacturing apparatus. Further, the process may be anything without being not particularly limited. For film formation, examples include CVD, PVD, a processing of forming an oxide film, a nitride film, or both, and a processing of forming a film containing a metal, among others, without being particularly limited to the film type. Furthermore, processes other than film formation, such as annealing, oxidation, nitridation, diffusion, etc. are also acceptable.

According to the present disclosure, it is possible to properly control cooling of a substrate.

While certain embodiments are described, these embodiments are presented by way of example, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

## Claims

1. A method of cooling a substrate (1) comprising:
transferring the substrate (1) from a process chamber (14) to a transfer chamber (3), after processing the substrate (1) disposed at the process chamber (14) while detecting a temperature by a temperature sensor (211) installed at a substrate support (31) configured to support the substrate (1); and
cooling the substrate (1) so that the temperature detected by the temperature sensor (211) becomes equal to or lower than a set temperature while the substrate support (31) is located at a predetermined position.

2. The method of Claim 1, wherein the temperature sensor (211) is configured to be operable together with the substrate support (31).

3. The method of Claim 1, wherein the temperature sensor (211) includes a plurality of temperature detectors (211b), and
wherein in the act of cooling the substrate (1), the substrate (1) is cooled until a temperature detected by each of the temperature detectors (211b) reaches the set temperature.

4. The method of Claim 3, wherein the substrate (1) is cooled until a temperature detected by a temperature detector (211b) located at a specific position, among the plurality of temperature detectors (211b), reaches the set temperature.

5. The method of Claim 1, wherein in the act of cooling the substrate (1), cooling of the substrate (1) is determined to be complete when the temperature detected by the temperature sensor (211) remains equal to or lower than the set temperature for a predetermined time.

6. The method of Claim 1, wherein in the act of cooling the substrate (1), a control target of the temperature sensor (211) is a cooler configured to cool the substrate (1).

7. A method of manufacturing a semiconductor device comprising the method of Claim 1, further comprising:
processing the substrate (1).

8. A substrate cooling system comprising:
a temperature sensor (211) installed at a substrate support (31) configured to support a substrate (1);
a transfer chamber (3) to which the substrate (1) is transferred from a process chamber (14), after the substrate (1) disposed at the process chamber (14) is processed while a temperature is detected by the temperature sensor (211); and
a controller (200) configured to be capable of cooling the substrate (1) at a cooler so that the temperature detected by the temperature sensor (211) becomes equal to or lower than a set temperature while the substrate support (31) is located at a predetermined position.

9. The substrate cooling system of Claim 8, wherein the cooler includes cooling parts configured to supply a coolant to the transfer chamber (3), and
wherein the controller (200) is configured to be capable of regulating a flow rate of the coolant from the cooling parts.

10. The substrate cooling system of Claim 9, wherein the cooling parts include one or more supply holes configured to supply the coolant at a position opposite to the temperature sensor, and
wherein the cooler is configured to be capable of changing the flow rate of the coolant for each of the supply holes.

11. The substrate cooling system of Claim 8, wherein the controller (200) further includes a determiner, and
wherein the determiner is configured to determine completion of cooling of the substrate (1) to proceed to a next step.

12. The substrate cooling system of Claim 11, wherein the temperature sensor (211) includes a plurality of temperature detectors (211b), and
wherein the determiner determines the completion of the cooling of the substrate (1) when a temperature detected by a temperature detector (211b) at a specific location, among the plurality of temperature detectors (211b), is equal to or lower than the set temperature.

13. The substrate cooling system of Claim 11, wherein the determiner determines the completion of the cooling of the substrate (1) when the temperature detected by the temperature sensor (211) remains equal to or lower than the set temperature for a predetermined time.

14. A substrate processing apparatus, comprising the substrate cooling system of Claim 8.

15. A program that causes, by a computer, a substrate processing apparatus to perform a process comprising:
transferring a substrate (1) from a process chamber (14) to a transfer chamber (3), after processing the substrate (1) disposed at the process chamber (14) while detecting a temperature by a temperature sensor (211) installed at a substrate support (31) configured to support the substrate (1); and
cooling the substrate (1) so that the temperature detected by the temperature sensor (211) becomes equal to or lower than a set temperature while the substrate support (31) is located at a predetermined position.
